(19) **Europäisches Patentamt / European Patent Office / Office européen des brevets**

(11) **EP 2 736 073 A1**

(12) # EUROPEAN PATENT APPLICATION

(43) Date of publication:
**28.05.2014 Bulletin 2014/22**

(51) Int Cl.:
***H01L 27/06*** (2006.01)  ***H03F 1/22*** (2006.01)
***H03K 17/081*** (2006.01)  ***H01L 27/088*** (2006.01)

(21) Application number: **12193609.0**

(22) Date of filing: **21.11.2012**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **NXP B.V.**
**5656 AG Eindhoven (NL)**

(72) Inventor: **Rutter, Phil**
**Redhill, Surrey RH1 1SH (GB)**

(74) Representative: **Crawford, Andrew**
**NXP B.V.**
**Intellectual Property & Licensing**
**Red Central**
**60 High Street**
**Redhill, Surrey RH1 1SH (GB)**

(54) **Cascode semiconductor device**

(57) A semiconductor device, comprising first (10) and second (14) field effect transistors arranged in a cascode configuration: wherein the first field effect transistor (10) is a depletion mode transistor; wherein the second field effect transistor (14) comprises a first inherent drain to source capacitance (C_mos) and a second additional drain to source capacitance (C_add) connected in parallel to the first drain to source capacitance. Also disclosed is a power factor correction circuit comprising the semiconductor device.

Fig.2

**Description**

FIELD OF THE INVENTION

The invention relates to a semiconductor device and in particular to a transistor cascode arrangement. More particularly, the invention relates to said cascode arrangement comprising Gallium Nitride based transistor devices. The invention also relates to a power factor correction circuit comprising said semiconductor device..

BACKGROUND OF THE INVENTION

In automotive electronics and high power RF technologies, devices such as III-V Gallium Nitride (GaN) HEMTs (High Electron Mobility Transistors) and SiC based JFETs (Junction Gate Field-Effect Transistors) have enabled high voltage, high current and low on-resistance operation thereby resulting in high power and high efficiency operation. The wide-band gap of GaN based devices offer robust and reliable devices capable of high voltage, high temperature operation. GaN technology is increasing in popularity due to better RF performance (lower capacitance and higher breakdown voltage) in comparison to LDMOS systems; and lower on state resistance compared to conventional vertical power MOSFETs used for example in power factor correction circuits which are used in power supplies for computing and portable communication devices.

GaN based devices are typically fabricated on silicon (Si), silicon carbide (SiC), and sapphire substrates. GaN HEMTs or SiC JFETs are depletion mode devices, therefore a negative gate voltage (when compared to the source voltage) and gate-drain biasing is required to switch the device. Such devices are therefore known as normally on devices. In other words when in use and without applying a gate source voltage the devices are in the on-state.

As a result of being normally on the input supply voltage is not isolated. Therefore at high voltages (for example 200 - 600 Volts) required for automotive and power supply applications, the inability to isolate the input voltage may increase the risk of damaging lower power ancillary circuits and components connected to such a high voltage device. Therefore driving a GaN or JFET power transistor is a challenge for a number of reasons. Most notably negative voltage biasing is required to switch such a normally on device.

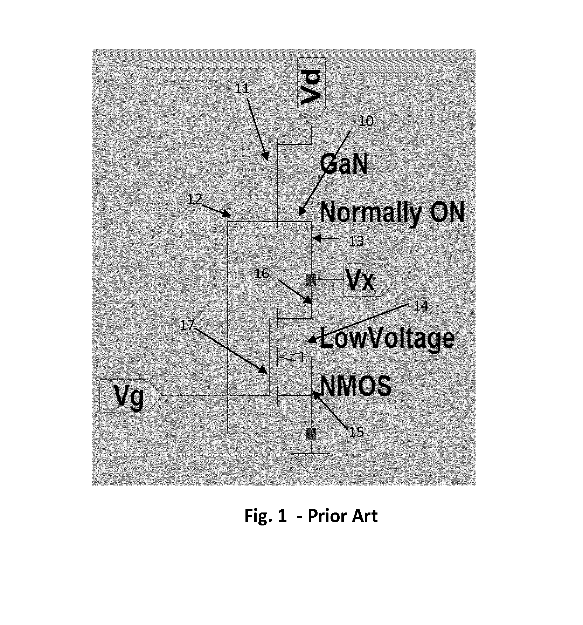

One known technique for creating a normally off switch for such high voltage normally on devices is to use a cascode arrangement. In such an arrangement a low voltage MOSFET is placed in the source of the high voltage device as illustrated in Figure 1. When the low voltage MOSFET is turned off, a negative gate voltage is created in the normally on high voltage device, thus turning off the high voltage device.

For the purposes of the following description the term high voltage device may be used interchangeably with the term GaN device. HEMTs are also known in the art as heterostructure FETs (HFET) or modulation-doped FETs (MODFET).

As shown in Figure 1 the low voltage MOSFET is an NMOS low voltage MOSFET device. The NMOS low voltage MOSFET is placed at the source of a high voltage device, where the drain of the low voltage MOSFET is connected to the source of the high voltage device. The source of the NMOS low voltage MOSFET and the drain of the high voltage device are connected across a power supply.

When the high voltage device is turned off, the drain-source voltage $V_{DS}$ of the low voltage MOSFET (shown as $V_x$ in Figure 1) is determined by Eqn. 1, given below. $V_X$ is a function of the threshold voltage of the high voltage device and the capacitances of the two cascode devices. In Eqn. 1 the capacitance $C_{OSS(MOS)}$ is equal to the sum of the gate drain capacitance $C_{GD}$ and the drain source capacitance $C_{DS}$ of the low voltage MOSFET device.

$$Vx = \frac{C_{DS(GaN)} \cdot V_d - (C_{OSS(MOS)} + C_{GS(GaN)}) \cdot V_{th(GaN)}}{C_{DS(GaN)} + (C_{OSS(MOS)} + C_{GS(GaN)})} \qquad \text{Eqn.1}$$

From Eqn. 1, $V_X$ which is the drain source voltage $V_{DS}$ of the low voltage MOSFET is dependent on the applied voltage $V_d$, which is limited by the maximum voltage rating, of the high voltage MOSFET device. Typically the maximum voltage rating of the high voltage MOSFET device will be in the range of 60 to 1000 Volts.

It is desirable to ensure that $V_x$ is a low as possible. As can be seen from Eqn. 1, an import factor in keeping $V_x$ low is the ratio of the capacitances of the low voltage MOSFET and high voltage devices, namely $C_{OSS(MOS)} \colon C_{DS(GaN)}$.

Firstly, $V_X$ should be low to ensure that the maximum gate source voltage $V_{GS}$ rating of the high voltage MOSFET device is not exceeded. For HEMT devices which may incorporate Schottky gates, the maximum $V_{GS}$ will be high due to the Schottky-diode gate arrangement. For devices using insulated gates $V_{GS}$ will be low.

Secondly, $V_X$ should be low, thereby reducing the drain source voltage $V_{DS}$ rating of the low voltage MOSFET. Reducing the $V_{DS}$ rating allows for a reduction in the size of the low voltage MOSFET device die. Reducing the low voltage MOSFET device die size is desirable in that it frees up space for the larger area high voltage devices in a given package, which ultimately results in a lower total Rds(on). This can be important when two or more devices are monolithically integrated on a single die.

For example, if the threshold voltage of the high voltage device (using a Schottky diode gate arrangement) $V_{th(GaN)}$ is -5 volts and a 25 volt rated low voltage device MOSFET (that is $V_X$ must be less than 25V) is then used for a maximum high voltage device rating of 600 V the capacitance ratio from Eqn. 1 will be:

$$\left(C_{OSS(MOS)} + C_{GS(GaN)}\right) > 28.75 . C_{GS(GaN)}$$

To limit $V_x$ to 10 volts, for example where the high voltage device uses an insulated gate the capacitance ratio would be 118.

By way of further example, for known cascode arrangements $V_x$ was found to be **<21.4** volts for a supply voltage $V_d$ of 200 volts, which equates to a capacitance ratio of approximately **8.** In order to increase the capacitance ratio it is possible to use a low voltage device with larger die size thereby increasing $C_{OSS}$. However, this is undesirable due to the increased cost of the device and larger physical area required to implement the cascode device.

Given that the high voltage device is the largest contributor to Rds(on) which is a function of both the breakdown voltage BVdss and the size of the device, its capacitances are effectively fixed for a given cascode device specification. Therefore, by keeping $V_x$ low, smaller, lower cost low voltage MOSFETs can be used whilst the reliability of the high voltage device will be enhanced, especially where an insulated gate is used. In a Schottky gate high voltage device, a lower value of Vx results in the gate leakage being significantly reduced.

If $V_x$ is high, one solution is to increase the $V_{DS}$ rating of the low voltage device. However, this is not effective since as the $V_{DS}$ rating increases, $C_{OSS}$ reduces and Rds(on) increases, thus requiring a larger more expensive die. An alternative solution, is to reduce $V_x$ and therefore the $V_{DS}$ rating of the MOSFET by increasing the die size of the low voltage MOSFET (thereby increasing its $C_{OSS}$ and improving the capacitance ratio). This solution is also undesirable as it leads to increased cost and area. A preferred solution is one that improves the capacitance ratio (to allow as low a $V_{DS}$ rating as possible) without resulting in an increase in the die size of the low voltage device.

Other known solutions exist but require control circuits thus adding additional device control terminals (or pins). Such solutions can be prohibitively costly for discrete transistor device implementations where the pin count should not exceed three.

There is therefore a need to overcome at least one of the problems mentioned above. Particularly there is a need to lower the $V_x$ (or $V_{DS}$ of the low voltage device) so that smaller lower cost low voltage devices can be used in cascode arrangements for high voltage normally on devices. In addition there is a need to improve the reliability of the high voltage device, particularly for devices with insulated gates. Current generation have Schottky gate where leakage is likely to be issue with high Vx, next generation May have insulated gates, which removes the leakage problem but will have a more stringent requirement on maximum gate voltage as a consequence.

SUMMARY OF INVENTION

There is provided a semiconductor device, comprising first and second field effect transistors arranged in a cascode configuration: wherein the first field effect transistor is a depletion mode transistor; wherein the second field effect transistor comprises a first inherent drain to source capacitance and a second additional drain to source capacitance connected in parallel to the first drain to source capacitance.

The second additional drain to source capacitance may be integrated on to the second field effect transistor. The second additional drain to source capacitance may be integrated under a gate connection of the second field effect transistor. The second additional drain to source capacitance may be integrated by deep trench isolation.

The second additional capacitance reduces the required drain source voltage enabling smaller device areas. Smaller low voltage device area allow for larger high voltages devices to be accommodated on the given semiconductor device die area. Where the high voltage device uses an insulated gate it is possible to reduce the maximum gate source voltage for the high voltage device thereby improving device reliability.

There is also provided a power factor correction circuit comprising the semiconductor device, and a power supply comprising said power factor correction circuit.

DESCRIPTION OF THE DRAWINGS

The invention is described further hereinafter by way of example only with reference to the accompanying drawings in which:

Figure 1 is a circuit diagram of a cascode arrangement according to the prior art;

Figure 2 is a circuit diagram of a cascode arrangement according to the present invention;

Figure 3 is die layout of low voltage MOSFET device with additional drain source capacitance $C_{ds}$; and

Figure 4 is a circuit diagram of a power factor correction circuit comprising the cascode arrangement.

Whilst the following relates to MOSFETs, JFETs and HEMTs, the skilled person will recognise any suitable transistors may be used. The skilled person will also recognise that any device voltage rating may be used as dependent on the specific application requirements.

As illustrated in Figure. 1 a known cascode arrangement includes a high voltage MOSFET device 10. The high voltage device 10 having source 13, gate 12 and drain 11 terminals. The cascode arrangement further includes a low voltage n-channel MOSFET 14. The low voltage MOSFET 14 can be an enhancement mode device. The low voltage MOSFET 14 and high voltage MOSFET 10 devices are arranged as a three terminal cascode. The gate 12 of the high voltage MOSFET 10 is connected to the source 15 of the low voltage MOSFET 14. The source 13 of the high voltage MOSFET 10 is connected to the drain 16 of the low voltage MOSFET 14.

The resulting cascode arrangement provides a three terminal device in which the drain 11 of the high voltage MOSFET device 10 is the drain terminal and the gate 17 and source 15 of the low voltage MOSFET device 14 provide the gate and source terminals respectively.

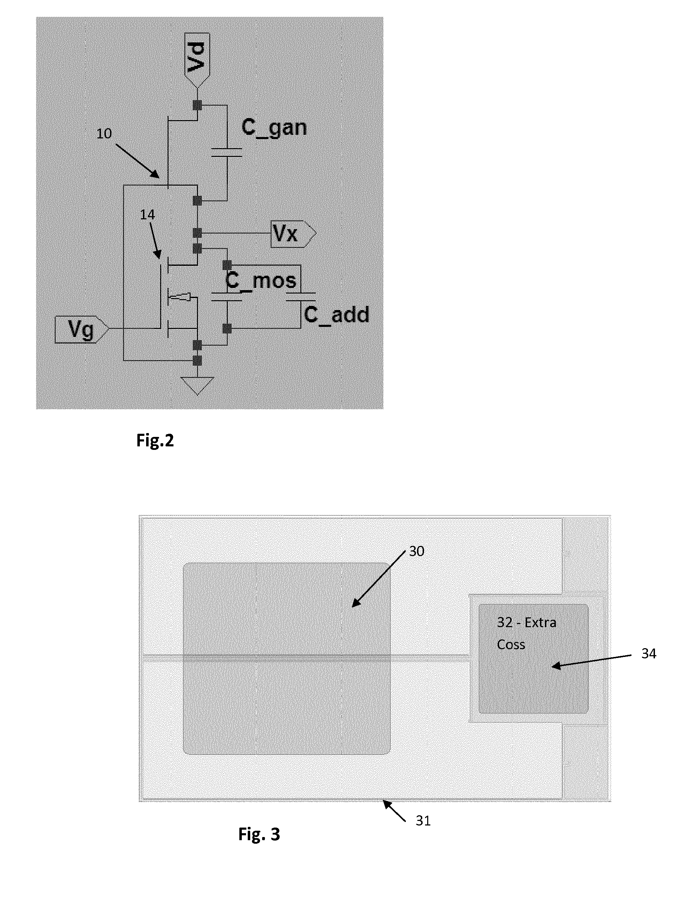

Figure 2 (in which like reference numerals correspond to like features in Figure 1) shows the cascode arrangement of Figure 1 with some additional circuit detail. The high voltage MOSFET device 10 may be a GaN HEMT or SiC JFET, with an inherent drain source capacitance $C_{\_gan}$ which is the inherent junction capacitance of the high voltage device 10. The skilled person will appreciate however, that any suitable normally on device may be used. Likewise the low voltage MOSFET 14 may be an N-channel MOSFET and has an inherent drain source capacitance $C_{\_mos}$ which is the inherent junction capacitance of the low voltage MOSFET 14.

An additional capacitance $C_{\_add}$ is provided across the drain and source of the low voltage MOSFET 14. The additional capacitance increases the effective drain source capacitance of the low voltage MOSFET, thereby reducing $V_x$. As described above, in relation to Eqn. 1 an important factor restricting $V_x$ (or $V_{DS}$) is the ratio of the capacitances of the high and low voltage MOSFET devices, namely $C_{OSS\_MOS}:C_{DS\_GaN}$. Therefore increasing the drain source capacitance of the low voltage MOSFET device 14 reduces $V_x$.

The additional capacitance $C_{\_add}$ may be included by integrating a separate capacitor into the overall device die containing both the high voltage and low voltage MOSFETs. Alternatively the high voltage and low voltage MOSFETs may be on separate dies, with the additional capacitance $C_{add}$ integrated on the cheaper low voltage MOSFET die. Alternatively the additional capacitance $C_{add}$ may be a discrete capacitance not integrated to on any die, but connected in parallel across the drain and source of the low voltage MOSFET. Alternatively the additional capacitance may be integrated onto the high voltage MOSFET.

It should be noted that the inductance of the connections introduced when connecting an additional capacitance will need to be taken into account to ensure that the additional capacitance remains effective during switching of the device 10. Typically the additional capacitor could be rated at 30V with a capacitance density of up to 25nF/mm$^2$.

Where the additional capacitance is integrated as a separate capacitor into the low voltage MOSFET 14 die this can be achieved by using deep trench isolation techniques to increase the $C_{OSS}$ (by increasing $C_{DS}$). For example, a typical capacitance per unit area will be in the region of 10 times the active area of the MOSFET, thus achieving a capacitance density of 1nF/mm$^2$ to 1.5nF/mm$^2$. Therefore any increase in the MOSFET die size required to meet the capacitance ratio discussed above will be limited to 10% of the increase compared to using standard MOSFETs (that is those that do not incorporate deep trench isolation capacitances).

Figure 3, illustrates the die layout of the low voltage MOSFET device 14, showing source 30, drain 31 and gate 34 connections. By way of example a vertical MOSFET device is shown. The additional capacitance 32 may be integrated in an area of the low voltage MOSFET device with a high metal spreading resistance such as under the gate connection 34. In this case, a typical device specification, for example may be a 3mm$^2$ die area, with a 30 volt $V_{DS}$ and a 4mΩ Rds(on) at a $V_{GS}$ of 10 volts. The $C_{OSS}$ of this specification will be in the region of 800pF. Integrating the capacitance in this way results in a doubling of the drain source capacitance with only a 5% increase in Rds(on).

In contrast, to the above example of, if the low voltage MOSFET device has the same die area of 3mm$^2$ but is designed to operate at 60 Volts $V_{DS}$ it will have a Coss of approximately 109pF, which is a factor of 8 lower than the example given above. However, this will result in a 6 times increase in Rds(on) to approximately 24.7 mΩ.

So whilst increasing $V_{DS}$ of the low voltage MOSFET from 30V to 60V may reduce the requirement on the capacitance ratio by a factor of 2 (by allowing $V_x$ to approximately double) for the same die area the capacitance ratio will be a factor of eight worse. So the net effect for 30 volt device comprising the additional capacitance will have approximately a factor of 4 better capacitance ratio than the 60 volt. Consequently, this means that that the die size required in a 60 volt device, in order to ensure the device will not avalanche, will need to be approximately four times the size of the 30 volt device with add the additional capacitance. The 60 volt device will also have approximately a 50% higher Rds(on).

It can be seen therefore that low voltage devices comprising the additional capacitance reduce device footprint and maintain a lower Rds(on) rating. This allows for larger high voltages devices to be accommodated on the given semiconductor device die area.

Applications of the described arrangement can include Power Factor Correction (PFC) circuits used to isolate AC-DC mains converter supplies used for mobile computing and telecommunications devices . In such power supplies the AC input effectively sees a large inductive load, which can causes the power factor of the power supply to be less than one. PFC circuits allow the AC input see a near unity power factor and also remove harmonic current distortion. Near unity power factors are now required by state and national laws depending on the output power of the power supply.

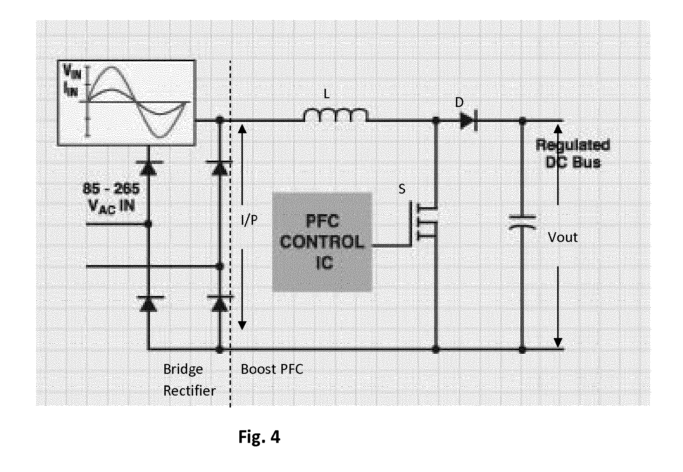

A common PCF circuit is the active boost PFC, which ensures that the current drawn from the supply is sinusoidal (i.e. harmonic free) and in phase with the current. This arrangement is illustrated in Figure 4.

The input I/P to the PFC circuit is a rectified AC mains voltage and the output is a rectified DC voltage. Rectification of the AC mains is achieved by way of the illustrated diode bridge circuit. The boost circuit itself consists of an inductor L, high voltage power switch S, and high voltage PFC diode D. The duty cycle of the high voltage switch S is controlled in a manner to regulate that output voltage $V_{out}$; ensuring a close to unity power factor, and to minimize harmonic current distortion. The PFC diode D can be a high voltage component and in high efficiency PFC circuits it can be fabricated in SiC or GaN due to the superior reverse recovery characteristics of these devices over silicon devices. In particular, it is possible to fabricate both the high voltage switch S and diode on the same die in a GaN HEMT process.

In this particular circuit, the high voltage input is connected to the drain of the high voltage switch S via an inductor with the source of the high voltage switch S connected to ground. It then follows that when not operating (that is no power applied to the switch), the high voltage switch must be turned off to prevent shorting of the input voltage to ground. Due to this requirement, a normally on device needs to be used in a cascode arrangement to convert it to a normally off device. To this end the cascode arrangement discussed above is suitable as a high voltage switch S to use in this PFC arrangement.

The cascode device , used in such a PFC application could also integrate the PFC diode into the same package. The cascode S and diode manufacturing processes may be compatible, such as in a GaN HEMT process, then these two components may be integrated onto a single die. Alternatively, the diode D may be integrated with either the low voltage MOSFET 14 or high voltage MOSFET 10 devices.

The described arrangements can also be used to monolithically integrate power devices with control integrated circuits for example in compact fluorescent lighting (CFL) applications.

Particular and preferred aspects of the invention are set out in the accompanying independent claims. Combinations of features from the dependent and/or independent claims may be combined as appropriate and not merely as set out in the claims.

The scope of the present disclosure includes any novel feature or combination of features disclosed therein either explicitly or implicitly or any generalisation thereof irrespective of whether or not it relates to the claimed invention or mitigate against any or all of the problems addressed by the present invention. The applicant hereby gives notice that new claims may be formulated to such features during prosecution of this application or of any such further application derived there from. In particular, with reference to the appended claims, features from dependent claims may be combined with those of the independent claims and features from respective independent claims may be combined in any appropriate manner and not merely in specific combinations enumerated in the claims.

Features which are described in the context of separate embodiments may also be provided in combination in a single embodiment. Conversely, various features which are, for brevity, described in the context of a single embodiment, may also be provided separately or in any suitable sub combination.

For the sake of completeness it is also stated that the term "comprising" does not exclude other elements or steps, the term "a" or "an" does not exclude a plurality, a single processor or other unit may fulfill the functions of several means recited in the claims and reference signs in the claims shall not be construed as limiting the scope of the claims.

## Claims

1. A semiconductor device, comprising first (10) and second (14) field effect transistors arranged in a cascode configuration:

wherein the first field effect transistor (10) is a depletion mode transistor;

wherein the second field effect transistor (14) comprises a first inherent drain to source capacitance ($C_{mos}$) and a second additional drain to source capacitance ($C_{add}$) connected in parallel to the first drain to source capacitance.

2. The semiconductor device of claim 1, wherein the second additional drain to source capacitance ($C_{add}$) is integrated on to the second field effect transistor (14).

3. The semiconductor device of claim 2, wherein the second additional drain to source capacitance ($C_{add}$) is integrated under a gate connection (34) of the second field effect transistor (14).

4. The semiconductor device of claim 2 or 3, wherein the second additional drain to source capacitance ($C_{add}$) is integrated by deep trench isolation.

5. The semiconductor device of any preceding claim, wherein the additional drain to source capacitance ($C_{add}$) is arranged to increase the junction capacitance of the second field effect transistor (14).

6. The semiconductor device of claim 1 wherein the first field effect transistor (10) is a High Electron Mobility Transistor or a Junction Gate Field Effect Transistor.

7. The semiconductor device of claim 1, wherein the second field effect transistor (14) is an N-channel transistor.

8. The semiconductor device of claims 1 to 5, wherein the first and second field effect transistors are integrated onto a single die.

9. The semiconductor device of any one or more of the preceding claims, wherein the second additional drain to source capacitance ($C_{add}$) is connected in parallel to a gate source capacitance of the first field effect transistor (10).

10. The semiconductor device of claim 9, wherein the second additional drain to source capacitance ($C_{add}$) is integrated on to the first field effect transistor (10).

11. A power factor correction circuit comprising the semiconductor device as claimed in any of claims 1 to 9.

12. The power factor correction circuit of claim 11, further comprising a power factor correction diode (D) wherein the power factor correction diode (D) is integrated with the semiconductor device in a single device package

13. A power factor correction circuit of claim 12, wherein the power factor correction diode is integrated with either the first or second field effect transistors of claims 1 to 7 in the same die.

14. A power supply comprising the power factor correction circuit of any one of claims 11 to 13.

**Fig. 1  - Prior Art**

**Fig.2**

**Fig. 3**

**Fig. 4**

Europäisches
Patentamt

European
Patent Office

Office européen
des brevets

# EUROPEAN SEARCH REPORT

Application Number

EP 12 19 3609

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2012/262220 A1 (SPRINGETT NIGEL [DE]) 18 October 2012 (2012-10-18) | 1-3,5-7 | INV. H01L27/06 H03F1/22 H03K17/081 |
| Y | * paragraphs [0035], [0037], [0049]; figure 1C * | 4 | |
| X | US 2009/167411 A1 (MACHIDA OSAMU [JP] ET AL) 2 July 2009 (2009-07-02) * paragraphs [0043], [0048], [0100], [0101], [0114]; figure 12 * | 1-3,5-8, 10 | ADD. H01L27/088 |
| X | US 2012/241756 A1 (ZHANG JASON [US] ET AL) 27 September 2012 (2012-09-27) | 1-3,5-10 | |
| Y | * paragraphs [0015], [0036] - [0038], [0040]; figures 1,3 * | 11-14 | |
| Y | US 2012/199875 A1 (BHALLA ANUP [US] ET AL) 9 August 2012 (2012-08-09) * paragraph [0052]; figure 4D * | 4 | |
| Y | US 2012/068186 A1 (OTREMBA RALF [DE]) 22 March 2012 (2012-03-22) * paragraphs [0018], [0019], [0028]; figure 1 * | 11,12,14 | TECHNICAL FIELDS SEARCHED (IPC) H01L H03F |
| Y | US 2010/019279 A1 (CHEN JING [CN] ET AL) 28 January 2010 (2010-01-28) * paragraph [0007]; figure 21 * | 11,13,14 | H03K |

The present search report has been drawn up for all claims

| Place of search | Date of completion of the search | Examiner |
|---|---|---|
| Munich | 5 March 2013 | Seck, Martin |

EPO FORM 1503 03.82 (P04C01)

## ANNEX TO THE EUROPEAN SEARCH REPORT
## ON EUROPEAN PATENT APPLICATION NO.

EP 12 19 3609

This annex lists the patent family members relating to the patent documents cited in  the above-mentioned European search report.
The members are as contained in the European Patent Office EDP file on
The European Patent Office is in no way liable for these particulars which are merely given for the purpose of information.

05-03-2013

| Patent document cited in search report | | Publication date | Patent family member(s) | | Publication date |
|---|---|---|---|---|---|
| US 2012262220 | A1 | 18-10-2012 | US 2012262220 A1 | | 18-10-2012 |
| | | | WO 2012141859 A2 | | 18-10-2012 |
| US 2009167411 | A1 | 02-07-2009 | JP 5130906 B2 | | 30-01-2013 |
| | | | JP 2009159222 A | | 16-07-2009 |
| | | | US 2009167411 A1 | | 02-07-2009 |
| US 2012241756 | A1 | 27-09-2012 | EP 2503691 A1 | | 26-09-2012 |
| | | | JP 2012212875 A | | 01-11-2012 |
| | | | US 2012241756 A1 | | 27-09-2012 |
| US 2012199875 | A1 | 09-08-2012 | CN 102629866 A | | 08-08-2012 |
| | | | US 2012199875 A1 | | 09-08-2012 |
| US 2012068186 | A1 | 22-03-2012 | CN 102412211 A | | 11-04-2012 |
| | | | DE 102011053519 A1 | | 22-03-2012 |
| | | | US 2012068186 A1 | | 22-03-2012 |
| US 2010019279 | A1 | 28-01-2010 | CN 101562182 A | | 21-10-2009 |
| | | | TW 201001669 A | | 01-01-2010 |
| | | | US 2010019279 A1 | | 28-01-2010 |

EPO FORM P0459

For more details about this annex : see Official Journal of the European Patent Office, No. 12/82